Europäisches Patentamt

European Patent Office

Office européen des brevets

(11) Publication number: **0 130 676**
**B1**

(12) **EUROPEAN PATENT SPECIFICATION**

(45) Date of publication of patent specification: **16.08.90**

(51) Int. Cl.⁵: **H 01 L 29/80, H 01 L 29/10**

(21) Application number: **84303165.9**

(22) Date of filing: **10.05.84**

(54) Semiconductor device having a hetero junction.

(30) Priority: **11.05.83 JP 80895/83**

(43) Date of publication of application:
**09.01.85 Bulletin 85/02**

(45) Publication of the grant of the patent:
**16.08.90 Bulletin 90/33**

(84) Designated Contracting States:
**DE FR**

(56) References cited:
**EP-A-0 067 721**

**JAPANESE JOUNRAL OF APPLIED PHYSICS,
vol. 19, no. 5, May 1980, pages L225-L227; T.
MIMURA et al.: "A new field-effect transistor
with selectively doped GaAs/n-AlxGa1-xAs
heterojunctions"**

**APPLIED PHYSICS LETTERS, vol. 38, no. 9, 1st
May 1981, American Institute of Physics, US;
H.L. STORMER et al.: "Influence of an undoped
(AlGa)As spacer on mobility enhancement in
GaAs-(AlGa)As superlattices"**

(73) Proprietor: **HITACHI, LTD.**
**6, Kanda Surugadai 4-chome
Chiyoda-ku, Tokyo 100 (JP)**

(72) Inventor: **Katayama, Yoshifumi
1303-9, Shimotomi
Tokorozawa-shi Saitama-ken (JP)**
Inventor: **Shiraki, Yasuhiro
1-106, 3-26-1 Hirayama
Hino-shi Tokyo (JP)**
Inventor: **Yamaguchi, Ken
2-5-12 Maesawa Higashikurume-shi
Tokyo (JP)**
Inventor: **Murayama, Yoshimasa
4-2-1-320 Maehara-cho
Konganei-shi Tokyo (JP)**
Inventor: **Sawada, Yasushi
3-1 Higashi-Koigakubo
Kokubunji-shi Tokyo (JP)**
Inventor: **Usagawa, Toshiyuki
4-14-6 Nishi-koigakubo
Kokubunji-shi Tokyo (JP)**
Inventor: **Maruyama, Eiichi
1572-3, Josuihoncho
Kodaira-shi Tokyo (JP)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

(56) References cited:

**SOLID-STATE DEVICES 1982, ESSDERC-SSSDT MEETING AT MUNICH, 13th-16th September 1982, Munich, DE, pages 25-50, Physik-Verlag, Weinheim, DE; M. ABE et al.: "Advanced device technology for high speed GaAs VLSI"**

(74) Representative: **Calderbank, Thomas Roger et al**
**MEWBURN ELLIS & CO. 2/3 Cursitor Street London EC4A 1BQ (GB)**

## Description

The present invention relates to a field-effect semicoductor device which is capable of operating at high speed. More particularly, it relates to a field-effect semiconductor device which controls carriers generated in the vicinity of a semiconductor heterojunction.

To enhance the performance of a field-effect semiconductor device (hereinafter abbreviated to "FET"), it is known first to employ a semiconductor material exhibiting a high electron mobility and secondly to shorten a channel length.

The employment of a semiconductor material having a high electron mobility will now be described.

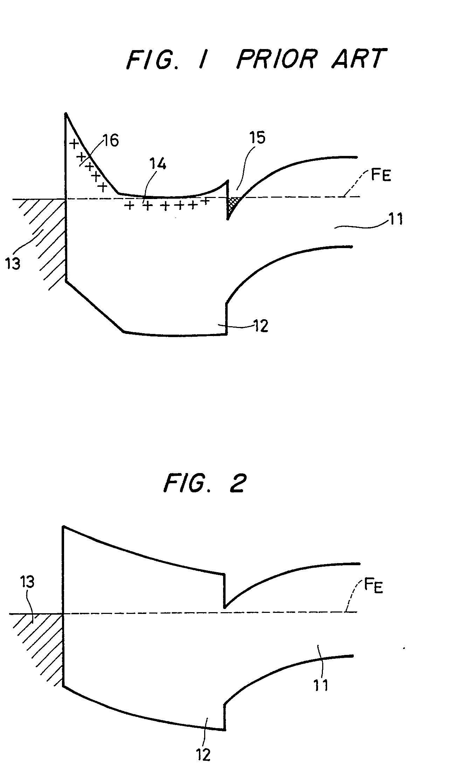

Gallium arsenide (GaAs) has an electron mobility much higher than that of silicon, and is a material suitable for fabricating a high speed device. It has been revealed that, when a gate insulator layer in a MOS (Metal-Oxide-Semiconductor) type field effect transistor is replaced with an aluminium gallium arsenide (AlGaAs) crystal which is doped with a donor impurity, carriers are induced at the interface of the latter, so a field effect transistor can be fabricated. Fig. 1 of the accompanying drawings is a band structure diagram of the active regions of this transistor. The transistor has an electrode portion 13, an AlGaAs layer 12 which contains an impurity, and a GaAs layer 11 which contains substantially no impurity. The Fermi level is shown by dotted line FE, and carriers 15 are confined in a two-dimensional potential. The carriers 15 are supplied from a donor impurity level 14 in the AlGaAs layer 12 and travel within the GaAs layer 11 containing no impurity, so that they are isolated in place from donor impurity ions. As a result, scattering due to impurity potentials decreases significantly, and a high mobility can be achieved. However, if the transistor is fabricated by use of electrons of a high mobility, the transconductance is lowered by the addition of multiple donors in the AlGaAs, although the gate voltage is effective for the interface region. To prevent this problem, it is desirable to use AlGaAs doped with no impurity to form the equivalent of a MOS structure. In the case of a Schottky type gate, however, gaps often appear between the channel and source and drain electrodes, unlike MOS structure. In such a case, the carriers are not induced in the gap portions when no donor impurity is added in AlGaAs or GaAs. The channel and the source and drain electrodes therefore cannot be connected, and problems are encountered in the operation of the transistor.

Examples of the high-speed field effect transistors thus far described are reported in the following:

(1) T. Mimura et al., Jpn. J. Appl. Phys. 19 (1980) L 225

(2) H. L. Störmer et al., Appl. Phys. Lett. 38 (1981) 691

(3) T. Mimura, Surf. Sci. 113 (1982) 454

A heterojunction field effect device normally has two semiconductor layers forming the heterojunction between them, two electrodes forming source and drain electrodes respectively and mean (e.g. the gate electrode) for controlling carriers between the source and drain. The two semiconductor layers may be formed of GaAs and AlGaAs respectively, AlGaAs having a wider forbidden band gap so that the edge of the conduction band of the first (GaAs) layer is lower than that of the second (AlGaAs) layer. In such a device, however, there is a risk of a punch-through current, and this is particularly liable to occur in a short-channel device which is favourable in the fabrication of an integrated circuit (IC).

It is known from EP—A—0067721 and an article by M. Ake et al entitled "Advanced device technology for high speed GaAs VLSI" in Solid-State Devices 1982, ESSDERC-SSSDT Meeting at Munich, 13—16 September 1982, Munich DE, Physik-Verlag, Weinheim, DE, to provide a low impurity region in one (the first) of the semiconductor layers forming the heterojunction. The low impurity region is located between the electrodes. Furthermore, the above two documents also show a high impurity concentration region adjoining the electrodes forming source and/or drain regions. Thus, these documents correspond to the precharacterising part of claim 1.

The present invention seeks to suppress further the spatial spread of current between the source and drain and restrain bulging towards the source of the equipotential lines around the drain. It does this by providing means for shielding electric fields around the at least one pair of electrodes, the shielding means comprising a shielding layer with a conductivity type opposite to that of the high impurity concentration region having an impurity concentration greater than the rest of the first semiconductor layer and being of small thickness, the shielding layer being located at a position which, in use, corresponds to the greatest potential bulge.

Preferably the shielding means has another shielding layer, with a conductivity type opposite to that of the high impurity concentration region, having an impurity concentration greater than the rest of its first semiconductor layer and being of small thickness, the other shielding layer being close to the interface of the first and second layers.

The shielding means may also have a further shielding layer, with a conductivity type the same as that of the high impurity concentration region.

In a heterojunction device consisting of a first layer of GaAs and a second layer of AlGaAs, the mobility of carriers in the channel between the source and drain regions may be made increased because the AlGaAs in the vicinity of the channel is devoid of impurities acting as scattering centres. The AlGaAs layer may act as the equivalent of the insulator layer in a MOS structure device, so that a voltage applied to a gate electrode on the AlGaAs layer may control the channel conduction, and the transconductance may be increased. The gaps between the channel and source and drain electrodes, discussed above, may be supplied with carriers from the donor impurity, so that efficient connection of the channel and the source and drain electrodes may be achieved, and the transistor can operate efficiently.

Preferably, the average impurity concentration of the low impurity concentration region between the source and drain regions is not higher than $10^{15}$ cm$^{-3}$, and the impurity concentration of the high impurity concentration regions adjoining the electrodes (the source and drain region themselves) is not lower than $10^{16}$ cm$^{-3}$.

Embodiments of the invention will now be described, by way of example, with reference to the accompanying drawings, in which:

Fig. 1 is an energy diagram of a prior art heterojunction field-effect transistor and has already been discussed;

Fig. 2 shows an energy diagram of a transistor according to the present invention;

Figs. 3 and 4 are diagrams for explaining the prior-art heterojunction field-effect transistor of Fig. 1;

Fig. 5 is a diagram for explaining the operating state of the heterojunction field-effect transistor of the present invention;

Figs. 6(a)—6(c) are sectional views showing steps in a manufacturing process for a field effect transistor according to the present invention;

Figs. 7(a)—7(d) are sectional views showing steps in a manufacturing process for constructing an integrated circuit.

In order to facilitate understanding of the present invention, a simple heterojunction field-effect transistor will first be considered.

If a hetero-structure field-effect transistor is made of AlGaAs and GaAs layers, the difference between the conduction bands of the GaAs and AlGaAs at the interface between the AlGaAs and the GaAs layers is approximately 0.3 eV, and the Schottky barrier is approximately 0.6 eV. Thus if AlGaAs doped with no impurity is employed, no channel is formed assuming that no gate voltage is applied. The band structure diagram in this case is shown in Fig. 2. Shown in Fig. 2 are an electrode portion 13, an AlGaAs layer 12, a GaAs layer 11, and the Fermi level $F_E$. The situation of Fig. 2 corresponds to a normally-off state, and the channel is formed by applying a positive voltage to the gate of the transistor. Thus, the transistor is of the enhancement mode type. On the other hand, the prior art, which uses AlGaAs doped with an impurity, results in a device with a normally-on state, and the transistor is of the depletion mode type. Even in the latter case, however, when the AlGaAs layer is very thin (about 500 Å), a depletion layer 16 (Fig. 1) based on the Schottky barrier extends to the AlGaAs metal, and a normally-off type device is achieved. By combining these two types of prior-art transistors, an integrated circuit can be fabricated. The integrated circuit, however, requires that the AlGaAs is thinned by etching for the enhancement-mode transistors and is thickened for the depletion-mode transistors. It is accordingly laborious to fabricate both these types of transistors on the same substrate. Another disadvantage is that the characteristics of the transistors disperse because of the low precision of the etching.

With the transistor of the present invention, the above problems may be solved, thereby to permit implementation of an IC. More specifically, in the course of producing a plurality of enhancement-mode transistors according to the present invention, only the required transistors need have an impurity introduced thereinto by, e.g., ion implantation, to change the potential profile and to change the threshold value of the gates. If necessary, the impurity concentration may be raised until the normally-on state is reached, so as to form depletion-mode transistors. Then, in order to prevent the influence of lattice defects formed by the ion implantation and an increase of the scattering probability of carriers due to the impurity itself, it is important that the ion implantation is performed under conditions in which the mean range of ions is at least 300 Å spaced from the hetero-interface. Ion implantation is a technique which is often utilized for the control of threshold values because it permits precise control of the quantity of an impurity. Thus, ion implantation is far superior in precision to etching, which is used in the prior art, and can reduce the dispersion of the characteristics of the transistors.

Next, the enhancement of performance achieved by shortening the channel length will be described. Instead of enhancing the performance of the device, the use of a shortened channel might result in the undesirable phenomenon called "punch-through". This will now be explained as to a hetero-structure field effect device (hereinafter abbreviated to "hetero-structure FET").

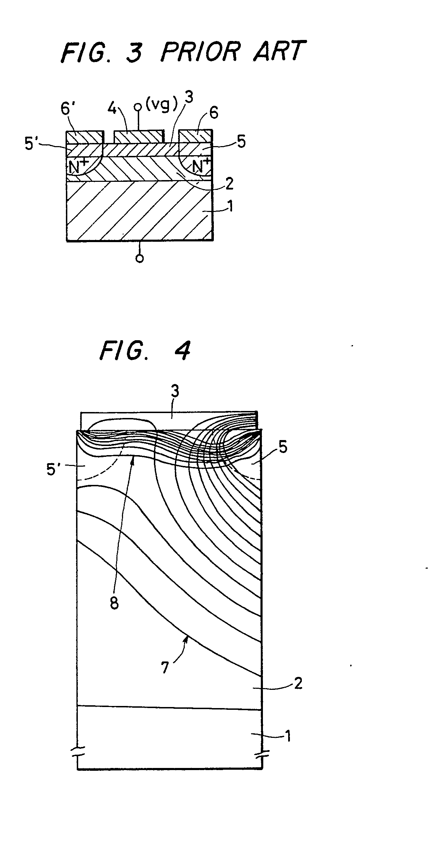

As shown by way of example in Fig. 3, a prior-art hetero-structure FET has a structure comprising a semi-insulating GaAs substrate 1, and n-type GaAs layer 2 and an n-type $Al_{0.3}Ga_{0.7}As$ layer 3 which are epitaxially grown on the substrate in succession, source and drain regions 5' and 5 which are formed in the layers 2 and 3, source and drain electrodes 6' and 6 and a gate electrode 4 which is disposed on the $Al_{0.3}Ga_{0.7}As$ layer 3.

In a hetero-structure semiconductor device, especially a hetero-structure FET of short channel intended to achieve a high density of integration, the drain current—gate voltage characteristic in a sub-threshold region is made worse by the source—drain punch-through phenomenon which is caused by an applied drain voltage $V_{DD}$. As compared with a hetero-structure semiconductor device of long channel, a hetero-structure semiconductor device of short channel has the unfavorable property that a punch-through current flows between the source and drain regions 5' and 5, and the drain current does not pinch off completely.

In contrast, the present invention permits the construction of a field-effect semiconductor device of short channel having punch-through suppressed and exhibiting good characteristics. The impurity concentration of the n-type GaAs layer 2 is made low, thereby to eliminate fluctuations of potential attributed to the impurity profile. Also, in order to suppress the spatial spread of the carrier profile, which is the cause of the flow of the punch-through current, a region, preferably in the shape of a thin layer, which contains a high concentration of an impurity opposite in conductivity type to the source (or drain) impurity is formed in a position near the interface between the n-type GaAs layer 2 and the n-type $Al_{0.3}Ga_{0.7}As$ layer 3. Moreover, in order to suppress the spatial spread of the so-called drain depletion region, one or more island-like impurity regions of an impurity opposite in conductivity type to the source (or drain) impurity are preferably formed in positions to which potential lines are liable to spread.

Before mentioning and describing practicable examples, the important points of the present invention will be discussed.

In a short-channel hetero-structure semiconductor device, the reason why the punch-through current flows is that the drain depletion region extends toward the source region, so the drain depletion region and the source depletion region directly influence each other. Such a situation is shown in Fig. 4. In that Figure, equipotential lines 7 which envelop and surround the drain region 5 bulge toward the source 5', and currents 8 which flow near the interface between a semiconductor body and an insulator film in the ordinary state involving no punch-through come away from the interface and spread in the depthwise direction of the body. As the channel length is made shorter, such spatial spread of the current profile becomes more marked, so that a greater punch-through current flows. Also shown in Fig. 4 are an AlGaAs layer 3, and a GaAs substrate 1.

In the present invention, two important concepts are considered in order to suppress punch-through. The first is to suppress the spatial spread of the current profile as shown in Fig. 4 and realize a unidimensional current profile. The second is to restrain the bulges of the equipotential lines from extending toward the source. That is, the invention achieves the effects of spatially and electrically shielding the drain electric field.

At least one layer, preferably two layers, are required forming a shielding impurity region which is provided in the n-type GaAs layer 2. The first layer (the optional layer) is preferably disposed in a position very close to the interface, while the second layer is preferably disposed in a position of the greatest potential bulge. These two layers should be formed of an impurity which is opposite in the conductivity type to the source (or drain) impurity. Moreover, it is desirable to form the layer(s) with high purity concentration(s) and with small thickness(es).

When two or more shielding impurity layers opposite in conductivity type to the source (or drain) impurity are provided in this manner, the threshold voltage is liable to become high. The rise of the threshold voltage, however, can be readily controlled by adding a layer forming a shielding region of an impurity identical in conductivity type to the source (or drain) impurity.

The first semiconductor layer, having a channel region in the FET of the present invention, has a low impurity concentration, which has an average density of not more than $10^{15}$ cm$^{-3}$ on the average. In addition, the high impurity concentration region adjoining the source or drain usually has an impurity concentration of at least $10^{16}$ cm$^{-3}$.

Preferably, the shielding impurity region to be formed in the first semiconductor layer is such that the product between its thickness and its impurity concentration lies between $5 \times 10^{11}$ cm$^{-2}$ and $1 \times 10^{13}$ cm$^{-2}$ inclusive.

The shielding impurity region is preferably provided at a depth between 50 and 1000 Å from the interface between the first and the second semiconductor layers. The first semiconductor layer and second semiconductor layer stated before form a heterojunction, and the forbidden band gap of the first semiconductor layer is set to be smaller than that of the second semiconductor layer. Thus, the edge of the conduction band of the first semiconductor layer is set to lie lower in energy than the edge of the conduction band of the second semiconductor layer. Therefore, the electron affinity of the first semiconductor layer is greater than that of the second semiconductor layer. The conductivity type of the shielding impurity region is p-type or n-type, and the thickness of this impurity layer is preferably 10 Å—500 Å, more preferably 10 Å—200 Å.

The shielding impurity regions in the first semiconductor layer may be formed by stacked layers of identical material. Further, as will be seen from embodiments to be described below, the shielding impurity regions need not be formed over the whole surface of the substrate but should be located between the source region 5' and the drain region 5 to produce the desired effects.

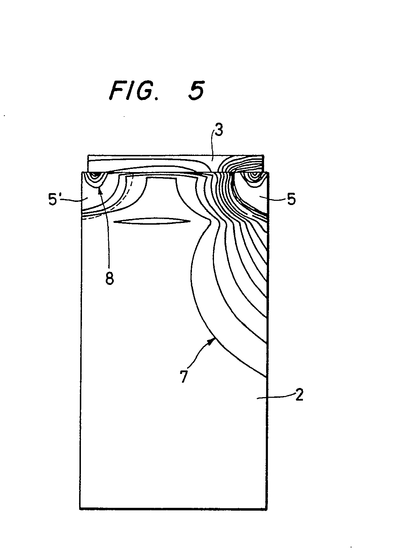

Next, an example of the analytical result of the internal operation of a heterojunction semiconductor device according to the present invention is shown in Fig. 5. As is apparent from the figure, the current profile 8 is limited to the vicinity of the interface, between the first and second semiconductor layers 2, 3 and also a potential profile (denoted by contour lines) demonstrates a pinning effect on the drain side. The other reference numerals in Fig. 5 correspond to the same parts as those in Fig. 4.

Such shielding effects based on the shielding impurity regions hold, not only in the hetero-structure FET, but also in other field effect devices.

Similar effects are produced when a layer of a semiconductor of large band gap, such as AlGaAs, is inserted instead of a shielding region containing impurity at a high concentration. The effects are noted at and above approximately 0.03 eV in terms of the difference of band gaps. They are more remarkable at and above approximately 0.05 eV. A layer having a difference of approximately 0.4 eV can also be used.

Embodiments of a field-effect semiconductor device according to the present invention will be explained below.

Embodiment 1:

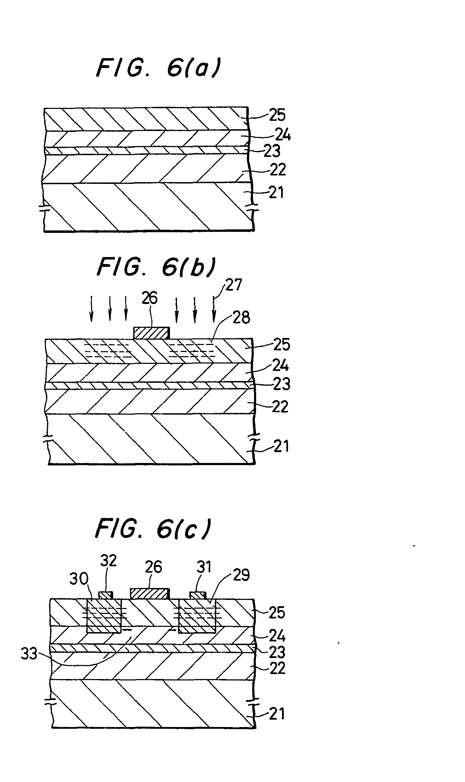

Figs. 6(a)—6(c) show the principal steps in the manufacture of such an FET.

A GaAs layer 22 which is not intentionally doped with any impurity is grown on a semi-insulating GaAs substrate 21 to a thickness of about 1 μm (usually set at approximately 5000 Å—1.5 μm) at a substrate temperature of 580°C by employing the well-known method of molecular beam epitaxy. Thereafter, a GaAs layer 23 which contains a p-type dopant in GaAs, such as Zn, with a density of about $2 \times 10^{18}$ cm$^{-3}$ (usually, $1 \times 10^{17}$—$1 \times 10^{20}$ cm$^{-3}$) is grown to about 20 Å (usually, 10 Å—500 Å) thereby to form a shielding region, and a GaAs layer 24 which is not intentionally doped with any impurity is grown to about 300 Å (this value is set at a suitable value between 50 Å and 2000 Å, depending upon the characteristics of the device required), in succession by the use of molecular beam epitaxy. The impurity-containing GaAs layer 23 may be a multilayer structure which consists of an n-type or p-type layer and a GaAs layer not doped with any impurity. Also, the layer 23 containing a p-type impurity may be replaced wiht a layer of a semiconductor having a greater band gap than GaAs, for example, with Al$_{0.3}$Ga$_{0.7}$As layer doped with no impurity. Furthermore, where a FET of large current capacity needs to be fabricated, a GaAs layer which is not intentionally doped with any impurity and which is, for example, 500 Å thick may be grown and a GaAs layer which contains an n-type dopant at a density of $5 \times 10^{17}$ cm$^{-3}$ and which is 20 Å thick (usually, 10—500 Å thick) may thereafter be grown by molecular beam epitaxy, in addition to the aforementioned p-type layer. This layer performs the role of the GaAs layer 23, i.e. forms a shielding region. An AlGaAs layer 25 in which the composition ratio between Al and Ga is about 0.3:0.7 is grown on the resultant structure to a thickness of approximately 1200 Å (selected from within a range of approximately 200—500 Å) by the use of molecular beam epitaxy and without intentionally adding any impurity. Fig. 6(a) shows this state.

A metal, for example titanium (Ti) or tungsten (W) forming a gate electrode 26, is deposited on the above epitaxy layer of the multilayer structure to a thickness of about 2 μm, whereupon using the metal electrode 26 as a mask for ion implantation (self-alignment), Si ions 27 are implanted at a dose of $2 \times 10^{13}$ cm$^{-2}$ by an acceleration voltage of 70 keV. Annealing is performed at 750°C for 30 minutes in order to remove lattice defects generated by the ion implantation and to activate the ions. The resulting impurity regions 28 are shown in Fig. 6(b). Annealing at a high temperature of 850°C enhances the activation rate of the ions. However, in order to prevent the blurring of the interface between the AlGaAs and GaAs and to prevent the diffusion of the impurities, the annealing is preferably conducted at the temperature mentioned previously.

Ge, Sn, Te, Se, S or the like may as the donor impurity be employed, as an alternative to Si. The impurity concentration of approximately $10^{13}$—$10^{14}$ cm$^{-3}$ to be ion-implanted is set, depending upon the extent to which carriers are to be generated, i.e. the required characteristics of the device. The energy of ion implantation differs depending upon the element to be implanted, but is normally set in a range of approximately 50 to 200 keV.

Subsequently, source 29 and drain 30 electrode regions 30 are formed in continuation to the ion-implanted layers by the conventional alloying, and electrodes 31, 32 of metal aluminium are formed on the source 29 and drain regions respectively. Then, the field effect transistor is completed. The carriers 33 induced at the interface are shown in Fig. 6(c).

The source and drain regions 29, 30 are formed so that, for example, an Au-Ge alloy (2000 Å), Ni (100 Å) and an Au-Ge alloy (3000 Å) are stacked on predetermined parts and are heated at 400°C in H$_2$ for about 5 minutes.

A transistor thus fabricated may have a mobility about 1.5 times and a transconductance about 3 times higher than those of prior-art heterojunction field effect transistors fabricated by doping AlGaAs with a donor at a density of about $2 \times 10^{18}$ cm$^{-3}$.

As in the prior-art method, it is possible to increase the transistor fabrication efficiency if a thin layer of GaAs, which is chemically more stable than AlGaAs, is grown on AlGaAs. The thickness of the layer is desirably approximately 300 Å—2000 Å.

Embodiment 2:

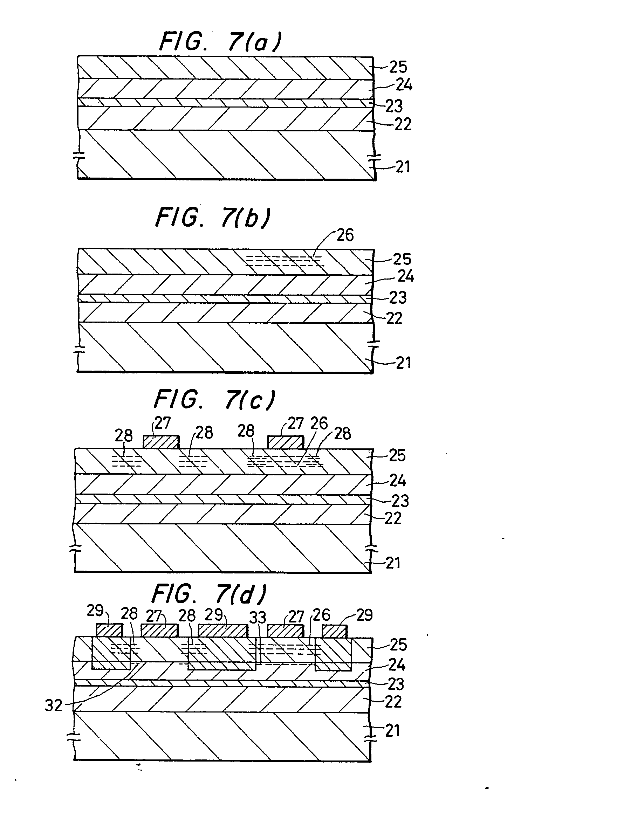

An example in which an integrated circuit is fabricated on a wafer will now be described with reference to Figs. 7(a) to 7(d). The fundamental arrangement in this embodiment is a pair of enhancement-mode and depletion-mode field effect transistors. First, similarly to Embodiment 1, a GaAs layer 22 which is not intentionally doped with any impurity and which is about 1 μm thick is grown on a semi-insulating GaAs substrate 21 at a substrate temperature of 580°C by molecular beam epitaxy, whereupon a GaAs layer 23 which contains Zn at a density of $10^{19}$ cm$^{-3}$ and which is about 20 Å thick, and a GaAs layer 24 which is not intentionally doped with any impurity and which is about 500 Å thick are successively grown using molecular beam epitaxy. Then, a GaAlAs layer 25 which is not intentionally doped is grown to about 1200 Å (Fig. 7(a)). Subsequently, the region to form the depletion-mode transistor is implanted with Si ions 26 at a density of $2 \times 10^{13}$ cm$^{-3}$ and an energy of 70 keV (Fig. 7(b)). As stated before, it is preferable to implant the ions only into the GaAlAs layer 25. Gate electrodes 27 are then formed, whereupon using those electrodes 27 as a mask, regions 28 to form the source and drain electrodes of both transistors are subjected to a second ion implantation under the same conditions as in Embodiment 1, and the impurity is activated by similar annealing. Thus, the enhancement-mode and depletion-mode transistors can be fabricated simultaneously (Fig. 7(c)).

Ge, Sn, Te, Se, S or the like as the donor impurity, may be employed as an alternative to Si. The impurity concentration to be ion-implanted is set to be approximately $10^{13}$ to $10^{14}$ cm$^{-3}$, depending upon the extent to which carriers are to be induced, i.e. the required characteristics of the device. The energy of the ion implantation differs depending upon the element to be implanted, but is normally set in a range of approximately 50 to 200 keV.

The source and drain regions are formed such that, for example, an Au-Ge alloy (2000 Å), Ni (100 Å) and an Au-Ge alloy (3000 Å) are stacked on predetermined parts and are heated at 400°C in H$_2$ for about 5 minutes (Fig. 7(d)).

While the above embodiments have been explained with reference to semiconductor devices constructed of GaAs-AlGaAs system, other materials adapted to construct heterojunctions are also suitable. They are, for example, Al$_y$Ga$_{1-y}$As-Al$_x$Ga$_{1-x}$As, GaAs-AlGaAsP, InP-InGaAsP, InP-InGaAs, InAs-GaAsSb, and IIInAs-GaInAs.

## Claims

1. A semiconductor device having a first (22, 23, 24) and a second (25) layer forming a heterojunction, an edge of the conduction band of the first semiconductor layer (22, 23, 24) being lower in energy than an edge of the conduction band of the second semiconductor layer (25) in the vicinity of the heterojunction, at least one pair of electrodes (31, 32) electrically connected to the first semiconductor layer (22, 23, 24), and means (26) to control carriers generated in the vicinity of the heterojunction: the first semiconductor layer (22, 23, 24) having a low impurity region (24) at least in the part of the first semiconductor layer (22, 23, 24) between the at least one pair of electrodes (31, 32); and

a high impurity concentration region (29, 30) adjoining each electrode of the at least one pair of electrodes (31, 32); characterized in that:

the first semiconductor layer includes means (23) for shielding electric fields around the at least one pair of electrodes (31, 32), that shielding means comprising a shielding layer with a conductivity type opposite to that of the high impurity concentration region (29, 30), having an impurity concentration greater than the rest of the first semiconductor layer and being of small thickness, the shielding layer being located at a position which, in use, corresponds to the greatest potential bulge.

2. A semiconductor device according to claim 1, wherein the shielding means (23) has another shielding layer with a conductivity type opposite to that of the high impurity concentration region (29, 30), having an impurity concentration greater than the rest of its first semiconductor layer and being of small thickness, the other shielding layer being close to the interface of the first and second layers.

3. A semiconductor device according to claim 1 or claim 2, wherein the shelding means (23) has a further shielding layer, with a conductivity type the same as that of the high impurity concentration region.

4. A device according to any one of claims 1 to 3 wherein the product of the impurity concentration and the thickness of the or each shielding region is between $5 \times 10^{11}$ cm$^{-2}$ and $1 \times 10^{13}$ cm$^{-2}$.

5. A device according to any one of claims 1 to 4 wherein the thickness of the or each shielding region is between 1 nm (10 Å) and 50 nm (500 Å).

6. A device according to claim 1, wherein the shielding means (23) includes a shielding region whose band-gap differs from that of the first semiconductor layer.

7. A device according to any one of the preceding claims wherein the average impurity concentration of the low impurity concentration region (24) does not exceed $10^{15}$ cm$^{-3}$ and the impurity concentrations of the high impurity concentration regions (29, 30) is not less than $10^{16}$ cm$^{-3}$.

## Patentansprüche

1. Halbleitervorrichtung mit einer ersten (22, 23, 24) und einer zweiten (25) Lage, die eine Hetero-Grenzschicht bilden, wobei die Leitungsband-Kante der ersten Halbleiterlage (22, 23, 24) in der Nähe der Hetero-Genzschicht eine niedrigere Energie aufweist als die der zweiten Halbleiterlage (25), mit mindestens einem Paar elektrisch mit der ersten Halbleiterlage (22, 23, 24) verbundener Elektroden (31, 32), und mit einer Einrichtung (26) zur Steuerung von Ladungsträgern, die in der Nähe der Hetero-Grenzschicht erzeugt werden; wobei die erste Halbleiterlage (22, 23, 24) zwischen dem Elektrodenpaar (31, 32) eine Zone (24) niedriger Störstellenkonzentration aufweist; und eine Zone (29, 30) höher Störstellenkonzentration angrenzend an jede Elektrode des Paars (31, 32), dadurch gekennzeichnet,

daß die erste Halbleiterlage eine Einrichtung (23) zur Abschirmung elektrischer Felder um das Elektrodenpaar (31, 32) beinhaltet, die eine dünne Abschirmlage mit einem zur Zone (29, 30) hoher Störstellenkonzentration gegensätzlichen Leitfähigkeitstyp und mit einer höheren Störstellenkonzentration als die übrige erste Halbleiterlage umfaßt, wobei die Abschirmlage an der Stelle angeordnet ist, die im Gebrauch der größten Potentialausbeulung entspricht.

2. Halbleitervorrichtung nach Anspruch 1, dadurch gekennzeichnet, daß die Abschirmeinrichtung (23) eine weitere dünne Abschirmlage mit einem zur Zone (29, 30) hoher Störstellenkonzentration gegensätzlichen Leitfähigkeitstyp und mit einer höheren Störstellenkonzentration als die übrige erste Halbleiterlage aufweist, wobei sich die weitere Abschirmlage dicht bei der Grenzschicht von erster und zweiter Halbleiterlage befindet.

3. Halbleitervorrichtung nach Anspruch 1 oder 2, dadurch gekennzeichnet, daß die Abschirmeinrichtung (23) eine weitere Abschirmlage mit dem gleichen Leitfähigkeitstyp wie die Zone hoher Störstellenkonzentration aufweist.

4. Vorrichtung nach einem der Ansprüche 1 bis 3, dadurch gekennzeichnet, daß das Produkt der Störstellenkonzentration und der Dicke der Abschirmzone bzw. jeder der Abschirmzonen zwischen $5\times10^{11}$ cm$^{-2}$ und $1\times10^{13}$ cm$^{-2}$ liegt.

5. Vorrichtung nach einem der Ansprüche 1 bis 4, dadurch gekennzeichnet, daß die Dicke der Abschirmzone bzw. jeder der Abschirmzonen zwischen 1 nm (10 Å) und 50 nm (500 Å) liegt.

6. Vorrichtung nach Anspruch 1, dadurch gekennzeichnet, daß die Abschirmeinrichtung (23) eine Abschirmzone beinhaltet, deren Bandlücke von der der ersten Halbleiterlage verschieden ist.

7. Vorrichtung nach einem der vorhergehenden Ansprüche, dadurch gekennzeichnet, daß die durchschnittliche Störstellenkonzentration der Zone (24) niedriger Störstellenkonzentration $10^{15}$ cm$^{-3}$ nicht überschreitet und die Störstellenkonzentration der Zone (29, 30) hoher Störstellenkonzentration nicht weniger als $10^{16}$ cm$^{-3}$ beträgt.

## Revendications

1. Dispositif à semiconducteurs possédant une première (22, 23, 24) et une seconde (25) couches formant une hétérojonction, un bord de la bande de conduction de la première couche semiconductrice (22, 23, 24) étant d'énergie inférieure à un bord de la bande de conduction de la seconde couche semiconductrice (25) au voisinage de l'hétérojonction, au moins une paire d'électrodes (31, 32) reliées électriquement à la première couche semiconductrice (22, 23, 24), et des moyens (26) pour commander des porteurs générés à proximité de l'hétérojonction; la première couche semiconductrice (22, 23, 24) possédant une région (24) à faible concentration en impuretés au moins dans la partie de la première couche semiconductrice (22, 23, 24) entre la paire d'électrodes (31, 32); et

une région à forte concentration en impuretés (29, 30) adjacente à chacune de la paire d'électrodes (31, 32); caractérisé en ce que:

la première couche semiconductrice comprend des moyens (23) pour arrêter des champs électriques autour de ladite paire d'électrodes (31, 32), en ce que les moyens d'arrêt comportent une couche de blindage d'un type de conductivité opposé à celui de la région à forte concentration en impuretés (29, 30), possédant une concentration en impuretés supérieure au reste de la première couche semiconductrice et étant de faible épaisseur, la couche d'arrêt étant disposée en un endroit qui, en utilisation, correspond à la plus grande courbure de potentiel.

2. Dispositif à semiconducteurs selon la revendication 1, dans lequel les moyens d'arrêt (23) possèdent une autre couche de blindage d'un type de conductivité opposé à celui de la région à forte concentration en impuretés (29, 30), possédant une concentration en impuretés supérieure au reste de sa première couche semiconductrice et étant de faible épaisseur, l'autre couche d'arrêt étant proche de l'interface des première et seconde couches.

3. Dispositif à semiconducteurs selon la revendication 1 ou la revendication 2, dans lequel les moyens d'arrêt (23) possèdent une autre couche de blindage, d'un type de conductivité identique à celui de la région à forte concentration en impuretés.

4. Dispositif selon l'une quelconque des revendications 1 à 3, dans lequel le produit de la concentration en impuretés et de l'épaisseur de la ou de chaque région d'arrêt est compris entre $5\times10^{11}$ cm$^{-2}$ et $1\times10^{13}$ cm$^{-2}$.

5. Dispositif selon l'une quelconque des revendications 1 à 4, dans lequel l'épaisseur de la ou de chaque région d'arrêt est compris entre 1 nm (10 Å) et 50 nm (500 Å).

6. Dispositif selon la revendication 1, dans lequel les moyens d'arrêt (23) comprennent une région d'arrêt dont l'intervalle de bande diffère de celui de la première couche semiconductrice.

7. Dispositif selon l'une quelconque des revendications précédentes, dans lequel la concentration en impuretés moyenne de la région à faible concentration en impuretés (24) ne dépasse pas $10^{15}$ cm$^{-3}$ et les concentrations en impuretés des régions à forte concentration en impuretés (29, 30) ne sont pas inférieures à $10^{16}$ cm$^{-3}$.

## FIG. 1 PRIOR ART

## FIG. 2

## FIG. 3 PRIOR ART

## FIG. 4

# FIG. 5

## FIG. 6(a)

## FIG. 6(b)

## FIG. 6(c)

# FIG. 7(a)

25
24
23
22
21

# FIG. 7(b)

26
25
24
23
22
21

# FIG. 7(c)

28  27  28  28  27 26  28
25
24
23
22
21

# FIG. 7(d)

29  28  27  28  29  33  27 26  29
25
24
23
22
32
21